# FASCICULE DE BREVET EUROPEEN

(11) **EP 3 845 976 B1**
(45) Date de publication et mention de la délivrance du brevet: **20.03.2024**
(21) Numéro de dépôt: 19220037.6
(22) Date de dépôt: 30.12.2019
(51) Int. Cl.: G04B 45/00, G04G 17/04

(54) **CADRAN DE MONTRE AYANT UN AFFICHAGE À BASE DE DIODES ÉLECTROLUMINESCENTES ORGANIQUES**
ZIFFERBLATT EINER ARMBANDUHR MIT EINER ANZEIGE AUF DER BASIS VON ORGANISCHEN LEUCHTDIODEN
WATCH DIAL HAVING A DISPLAY MADE OF ORGANIC LIGHT-EMITTING DIODES

(43) Date de publication de la demande: 07.07.2021
(73) Titulaire: The Swatch Group Research and Development Ltd, 2074 Marin (CH)
(72) Inventeur: BLANCKAERT, Nicolas, 2017 Boudry (CH); BARRON, Cécile, 2035 Corcelles (CH); THIAULT, Jérôme, 2013 Colombier (CH); GERNEZ, Cyrille, 2017 Boudry (CH)
(74) Mandataire: ICB SA

(56) Documents cités:
- US-A1- 2003 042 847
- US-A1- 2005 040 758

## Description

### Domaine Technique

L'invention concerne un cadran de montre ayant un affichage à base de diodes électroluminescentes organiques, une montre comprenant ledit cadran de montre et un procédé de fabrication d'un cadran de montre ayant un affichage à base de diodes électroluminescentes organiques.

### Arrière-plan technologique

Un affichage à base de diodes électroluminescentes organiques (« organic light-emitting diode » (OLED) en anglais) est composé de plusieurs couches de matériaux organiques prisent en sandwich entre deux électrodes. L'émission de lumière se fait dans une des couches de matériaux organiques lorsqu'un courant la traverse (l'affichage est dans un état dit « ON »). Si on souhaite localiser les zones d'émission de lumière entre les deux électrodes, une couche isolante électriquement, dite de passivation, est ajoutée sur l'une des électrodes. Cette couche de passivation est transparente. Le rendu final d'un affichage OLED de type « bottom émission » à l'état dit « OFF », c'est-à-dire sans courant traversant, est soit de la couleur de la cathode (aspect métallique), soit complètement noir si un polariseur circulaire est placé sur l'affichage OLED. US 2003/042847 A1 concerne un appareil d'émission d'affichage qui irradie une unité d'affichage optiquement transparente avec des rayons de lumière ultraviolette depuis le dessous pour amener les couches luminescentes disposées sur l'unité d'affichage à émettre des rayons de lumière colorés pour fournir un affichage très coloré et très ornemental. US 2005/040758 A1 concerne des dispositifs électroluminescents, et procédés de fabrication et d'utilisation de tels dispositifs. Les dispositifs électroluminescents comprennent une couche à motifs sur une couche sensible aux solvants. Les dispositifs électroluminescents peuvent être utilisés, par exemple, comme dispositifs d'affichage couleur.

### Description générale de l'invention

Conformément à la présente invention, il est proposé un cadran de montre et un procédé de fabrication correspondant selon les revendications indépendantes 1 et 16. Les modes de réalisation préférés sont définis dans les revendications dépendantes 2 à 15 ; 17, 18.

Il sera apprécié que le cadran de montre ayant un affichage à base de diodes électroluminescentes organiques peut être décoratif même lorsque l'affichage est dans un état « OFF ». En effet, la structure de la couche structurée de résine colorée permet de réaliser, p. ex., un motif dans lequel des parties de la cathode sont visibles, ou au moins partiellement visibles, et d'autres parties sont cachées par la couche structurée de résine colorée. Ceci est en contraste avec les solutions de l'art antérieur dans lesquelles, à l'état « OFF », seule une couleur uniforme est visible (métallique ou noire si un polariseur circulaire est placé sur l'affichage).

Selon un mode de réalisation, plusieurs résines colorées, ayant différentes couleurs, peuvent être utilisées pour former la couche structurée.

Selon un mode de réalisation, les couches organiques sont semiconductrices.

La couche structurée de résine colorée peut être recouverte par une couche électriquement isolante. Par couche électriquement isolante, on entend une couche formée de matériaux dont la conductivité électrique n'excède pas 10⁻⁸ Siemens/cm. Il sera apprécié que le fait de recouvrir la couche structurée par une couche électriquement isolante permet d'utiliser des résines qui sont éventuellement électriquement conductrices tout en conservant un motif décoratif à l'état « ON » ayant un fort contraste.

Des canaux de conduction entre l'anode et la cathode peuvent être créés par des lacunes de la couche structurée de résine colorée. Typiquement l'épaisseur du ou des couches de résine colorée est comprise entre 500 nm et 2 microns.

Selon un mode de réalisation, la cathode est en aluminium. Selon un mode de réalisation préféré, l'épaisseur de la cathode est comprise dans l'intervalle allant de 50 nm à 100 nm. Préférablement, la cathode est réfléchissante.

L'anode peut être transparente, et est préférablement en oxyde d'indium-étain (aussi appelée couche ITO). L'épaisseur de l'anode peut être comprise dans l'intervalle allant de 100 nm à 200 nm.

L'épaisseur de l'empilement organique peut être comprise dans l'intervalle allant de 100 nm à 200 nm.

Selon un mode de réalisation préféré, l'anode et/ou la cathode sont structurées. Il sera apprécié que la structuration permet de sélectivement mettre certaines zones dans l'état « ON » et d'autres dans l'état « OFF ». Il est ainsi possible d'afficher des informations à la demande, telles que l'heure, la date du jour, et/ou un logo.

Selon un mode de réalisation, une couche imprimée digitalement par jet d'encre peut être ajoutée sur l'électrode transparente.

Un second aspect de l'invention concerne une montre comprenant un cadran de montre tel que décrit ci-dessus.

Le dépôt de la couche structurée de résine colorée est réalisée par jet d'encre, par sérigraphie, par flexographie et/ou par héliographie.

Une couche électriquement isolante peut être déposée sur la couche structurée de résine colorée avant le dépôt de l'empilement de couches organiques.

L'empilement de couches organiques peut être réalisé par évaporation sous vide, par dépôt par phase vapeur et/ou par impression digitale par jet d'un ou plusieurs matériaux organiques, éventuellement semi-conducteurs, à déposer pour former l'empilement.

### Brève description des dessins

D'autres particularités et caractéristiques de l'invention ressortiront de la description détaillée de certains modes de réalisation avantageux présentés ci-dessous, à titre d'illustration, avec référence aux dessins annexés qui montrent :
**Fig. 1****:** une coupe transversale simplifiée d'un affichage de cadran de montre à base de diodes électroluminescentes organiques, selon un mode de réalisation préféré de l'invention ;
**Fig. 2****:** un motif décoratif à l'état « OFF » d'un affichage de cadran de montre ayant un affichage à base de diodes électroluminescentes organiques selon un mode de réalisation de l'invention ; et
**Fig. 3****:** un motif décoratif d'un affichage de cadran de montre ayant un affichage à base de diodes électroluminescentes organiques selon un mode de réalisation de l'invention.

### Description détaillée de plusieurs modes de réalisation de l'invention

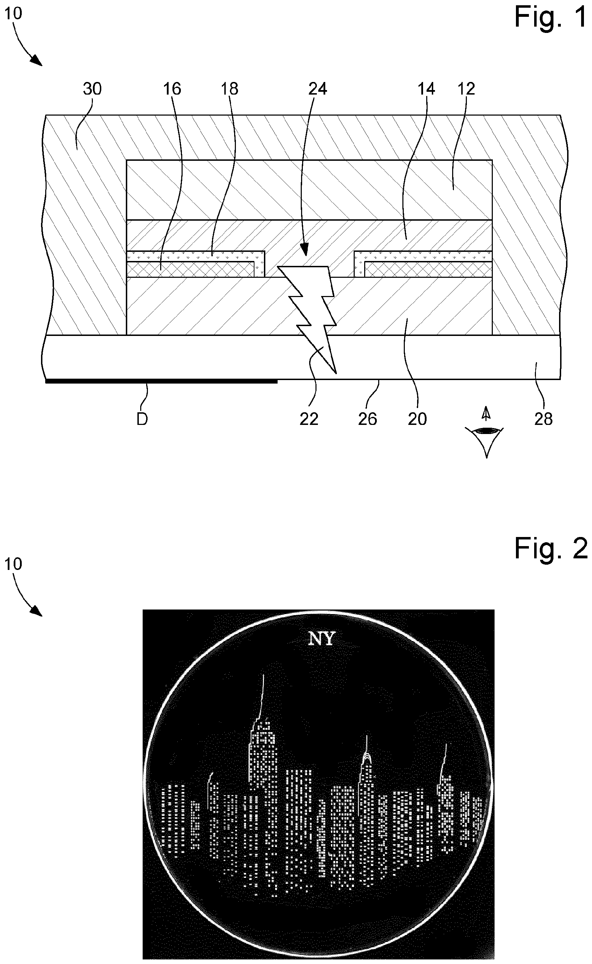

La Fig. 1 montre une coupe transversale simplifiée d'un affichage 10 de cadran de montre selon un mode de réalisation de l'invention préféré de l'invention. L'affichage 10 est à base de diodes électroluminescentes organiques. L'affichage comprend une cathode 12 réfléchissante en aluminium, un empilement de couches organiques 14, une couche structurée de résine colorée 16 (cette couche de résine étant revêtue d'une couche électriquement isolante 18 lorsque la couche de résine 16 est semiconductrices) et une anode 20 transparente en oxyde d'indium-étain déposée sur un substrat de verre (non représenté). L'affichage est à émission vers le bas (« bottom émission » en anglais) dans le sens où la lumière émise par l'empilement de couches organiques 14 sort de l'affichage 10 par l'anode 20 et le substrat.

La cathode 12 et l'anode 20 sont configurées pour créer une différence de potentiel. Cette différence de potentiel peut induire un courant dans le cas où le ou les matériaux placés entre la cathode 12 et l'anode 20 sont conducteurs d'électricité. En particulier, l'empilement de couches organiques 14 placé entre la cathode 12 et l'anode 20 est conducteur ou semi-conducteur, permettant ainsi au courant de passer au travers de l'empilement. Au moins une des couches de l'empilement de couches organiques 14 est électroluminescente. L'émission de lumière de la couche électroluminescente est le résultat de la recombinaison radiative des électrons et des trous formant le courant dans ladite couche électroluminescente. La longueur d'onde émise par la couche électroluminescente dépend entre autre du matériau de la couche électroluminescente.

Comme indiqué plus haut, l'affichage comprend une couche structurée de résine colorée 16 revêtue d'une couche électriquement isolante 18. La couche électriquement isolante 18 empêche le passage d'un courant entre la cathode et l'anode. Ainsi, aucun courant n'est présent dans les zones comprenant la couche électriquement isolante 18. Il est à noter qu'il n'est pas nécessaire de revêtir la résine colorée d'une couche électriquement isolante sur toute sa surface. Seules les zones qui seraient en contact direct avec l'empilement sont à revêtir (voir Fig. 1). La résine colorée peut, en plus d'être décorative (c'est-à-dire de former un décor intérieur à l'affichage), réaliser la fonction de la couche électriquement isolante 18 dans le cas où celle-ci est elle-même électriquement isolante.

La couche structurée de résine colorée 16 est structurée de façon à comprendre des lacunes 24 dans lesquelles l'empilement de couches organiques est en contact direct avec l'anode 20 (voir Fig. 1). Des canaux de conduction verticaux sont créés entre l'anode 20 et la cathode 12 par les lacunes 24. Par conséquent, des zones localisées d'émission de lumière sont créées dans l'affichage.

La structuration de la couche de résine colorée 16 peut permettre de mettre à disposition des affichages avec des motifs décoratifs visibles tant à l'état « OFF » (sans émission de lumière) qu'à l'état « ON » (avec émission de lumière). La Fig. 2 représente par exemple un affichage montrant des gratte-ciels de New-York à l'état « OFF ». Les zones représentées noires sont des zones recouvertes d'une résine noire. Les zones représentées blanches (p. ex les fenêtres) sont des zones dépourvues de résines (lacunes) rendant la cathode visible. La cathode étant réfléchissante, la lumière incidente arrivant dans les zones laissant apparaitre la cathode est réfléchie vers l'utilisateur de la montre et donne un aspect métallique. À l'état « ON », les zones dépourvues de résine sont traversées par un courant et s'illuminent grâce à l'émission de lumière dans la couche électroluminescente.

L'épaisseur de la cathode 12 est comprise dans l'intervalle allant de 50 nm à 100 nm. L'épaisseur de l'anode 20 est comprise dans l'intervalle allant de 100 nm à 200 nm. L'épaisseur de l'empilement 14 est comprise dans l'intervalle allant de 100 nm à 200 nm. L'épaisseur des couches 16 et 18 sont chacune comprise en 500 nm et 1 micron.

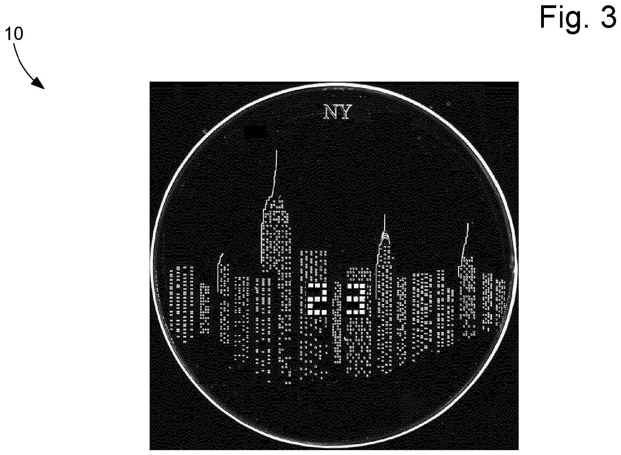

La cathode 12 et/ou l'anode 20 peuvent être structurées. Dans ce cas, il est possible de sélectivement allumer certaines zones de l'affichage (seules certaines zones de l'affichage sont alors dans l'état « ON »). Le contrôle des zones à éclairer ou non peut être réalisé par l'intermédiaire d'un circuit de commande. De cette façon, il est possible d'afficher des informations, telles que l'heure ou la date du jour. La Fig. 3 représente un tel cas. Le chiffre « 23 » est affiché par un passage de courant alors qu'aucun courant ne passe dans le reste du motif décoratif (il n'y a pas de lumière émise au niveau des fenêtres). Les fenêtres restent bien visibles même si aucune lumière n'est émise de celles-ci.

Un décor extérieur D peut être disposé sur la surface 26, qui est du côté de l'utilisateur, d'un substrat 28 portant l'affichage 10, ce dernier étant en recouvert d'une matériau d'enrobage isolant 30. Le décor D est typiquement appliqué par impression par exemple par impression par jet d'encre. Alternativement, le décor peut être déposé sur la surface 26 par sérigraphie, par tampographie, par flexographie et/ou par héliographie.

Selon un mode réalisation alternatif, l'affichage 10 illustré à la Fig. 1 pourrait être à émission vers le haut (« top émission » en anglais). Ce mode de réalisation diffère du mode de réalisation illustré à la Fig. 1 en ce que la cathode est transparente et l'anode est réfléchissante.

Le procédé de fabrication du cadran tel que décrit ci-dessus comprend les étapes successives suivantes : le dépôt et la structuration de l'anode 20 sur le substrat en verre, le dépôt et la structuration d'une couche de résine colorée sur l'anode, le dépôt et la structuration d'une couche électriquement isolante sur la couche structurée de résine colorée, le dépôt et structuration d'un empilement de couches organiques sur l'anode et la couche de résine colorée structurée (au moins une des couches organiques est une couche électroluminescente) et le dépôt d'une cathode sur l'empilement de couches organiques.

Le dépôt et la structuration peuvent être réalisés par photolithographie, par jet d'encre, par sérigraphie, par flexographie et/ou par héliographie. La résine est préférablement photosensible pour le dépôt et la structuration par photolithographie.

Le dépôt de l'empilement de couches organiques peut être réalisé par évaporation sous vide, par dépôt par phase vapeur et/ou par impression digitale par jet d'un ou plusieurs matériaux, éventuellement semi-conducteurs, organiques à déposer pour former l'empilement.

## Revendications

1. Cadran de montre ayant un affichage (10) à base de diodes électroluminescentes organiques, l'affichage comprenant :
une anode (20) ;
une couche structurée (16) de résine colorée ;
un empilement de couches organiques (14) en contact avec l'anode et avec
la couche structurée de résine colorée, ladite couche structurée de résine colorée étant structurée de manière à comprendre des lacunes (24) dans lesquelles l'empilement de couches organiques est en contact direct avec l'anode et au moins une des couches organiques étant une couche électroluminescente ; et
une cathode (12) en contact avec l'empilement de couches organiques

2. Cadran de montre selon la revendication 1, dans lequel la couche structurée de résine colorée est recouverte par une couche électriquement isolante.

3. Cadran de montre selon l'une quelconque des revendications 1 à 2, dans lequel la couche structurée de résine colorée comprend des lacunes dans lesquelles l'empilement de couches organiques est en contact direct avec l'anode.

4. Cadran de montre selon l'une quelconque des revendications 1 à 3, dans lequel des canaux de conduction entre l'anode et la cathode sont créés par des lacunes de la couche structurée de résine colorée.

5. Cadran de montre selon l'une quelconque des revendications 1 à 4, dans lequel la cathode est réfléchissante.

6. Cadran de montre selon l'une quelconque des revendications 1 à 5, dans lequel la cathode est en aluminium.

7. Cadran de montre selon l'une quelconque des revendications 1 à 6, dans lequel l'épaisseur de la cathode est comprise dans l'intervalle allant de 50 nm à 100 nm.

8. Cadran de montre selon l'une quelconque des revendications 1 à 7, dans lequel l'anode est en oxyde d'indium-étain.

9. Cadran de montre selon l'une quelconque des revendications 1 à 8, dans lequel l'épaisseur de l'anode est comprise dans l'intervalle allant de 100 nm à 200 nm.

10. Cadran de montre selon l'une quelconque des revendications 1 à 9, dans lequel l'épaisseur de l'empilement est comprise dans l'intervalle allant de 100 nm à 200 nm.

11. Cadran de montre selon l'une quelconque des revendications 1 à 10, dans lequel l'anode et/ou la cathode sont structurées.

12. Cadran de montre selon l'une quelconque des revendications 1 à 11 dans lequel l'épaisseur de la couche structurée de résine colorée en contact avec l'anode est comprise en 500 nm et 1 micron.

13. Cadran de montre selon l'une des revendications 2 à 12 dans lequel l'épaisseur de la couche électriquement isolante est comprise en 500 nm et 1 micron.

14. Cadran de montre selon l'une quelconque des revendications précédentes, dans lequel un décor D est disposé sur la surface d'un substrat portant l'affichage, ladite surface étant disposé du côté visible par l'utilisateur.

15. Montre comprenant un cadran de montre selon l'une quelconque des revendications 1 à 14.

16. Procédé de fabrication d'un cadran de montre ayant un affichage (10) à base de diodes électroluminescentes organiques comprenant le dépôt d'une anode (20); le dépôt d'une couche structurée (16) de résine colorée sur l'anode, ladite couche structurée de résine colorée étant structurée de manière à comprendre des lacunes (24) dans lesquelles un empilement de couches organiques (14) est en contact direct avec l'anode ; le dépôt et la structuration d'un empilement de couches organiques (14) sur l'anode et la couche de résine colorée structurée, au moins une des couches organiques étant une couche électroluminescente ; et le dépôt d'une cathode (12) sur l'empilement de couches organiques

17. Le procédé selon la revendication 16, dans lequel le dépôt de la couche structurée de résine colorée est réalisée par photolithographie, par jet d'encre, par sérigraphie, par flexographie et/ou par héliographie.

18. Le procédé selon l'une quelconque des revendications 16 à 17, dans lequel une couche électriquement isolante est déposée sur la couche structurée de résine colorée avant le dépôt de l'empilement de couches organiques.

## Patentansprüche

1. Uhrenzifferblatt mit einer organischen leuchtdiodenbasierte Anzeige (10), wobei die Anzeige Folgendes umfasst:
eine Anode (20);
eine strukturierte Schicht (16) aus farbigem Harz;
einen organischen Schichtstapel (14) in Kontakt mit der Anode und der strukturierten Schicht aus farbigem Harz, wobei die strukturierte Schicht aus farbigem Harz derart strukturiert ist, dass sie Lücken (24) umfasst, in denen der organische Schichtstapel in direktem Kontakt mit der Anode und
mindestens einer der organischen Schichten, die eine lichtemittierende Schicht ist, steht; und
eine Kathode (12) in Kontakt mit dem organischen Schichtstapel.

2. Uhrenzifferblatt nach Anspruch 1, wobei die strukturierte Schicht aus farbigem Harz mit einer elektrisch isolierenden Schicht beschichtet ist.

3. Uhrenzifferblatt nach einem der Ansprüche 1 bis 2, wobei die strukturierte Schicht aus farbigem Harz Lücken umfasst, in denen der organische Schichtstapel in direktem Kontakt mit der Anode steht.

4. Uhrenzifferblatt nach einem der Ansprüche 1 bis 3, wobei durch die Lücken in der strukturierten Schicht aus farbigem Harz Leitungskanäle zwischen der Anode und der Kathode geschaffen werden.

5. Uhrenzifferblatt nach einem der Ansprüche 1 bis 4, wobei die Kathode reflektierend ist.

6. Uhrenzifferblatt nach einem der Ansprüche 1 bis 5, wobei die Kathode aus Aluminium besteht.

7. Uhrenzifferblatt nach einem der Ansprüche 1 bis 6, wobei die Dicke der Kathode im Bereich von 50 nm bis 100 nm liegt.

8. Uhrenzifferblatt nach einem der Ansprüche 1 bis 7, wobei die Anode aus Indium-Zinn-Oxid besteht.

9. Uhrenzifferblatt nach einem der Ansprüche 1 bis 8, wobei die Dicke der Anode im Bereich von 100 nm bis 200 nm liegt.

10. Uhrenzifferblatt nach einem der Ansprüche 1 bis 9, wobei die Dicke des Stapels im Bereich von 100 nm bis 200 nm liegt.

11. Uhrenzifferblatt nach einem der Ansprüche 1 bis 10, wobei die Anode und/oder die Kathode strukturiert sind.

12. Uhrenzifferblatt nach einem der Ansprüche 1 bis 11, wobei die Dicke der strukturierten Schicht aus farbigem Harz in Kontakt mit der Anode zwischen 500 nm und 1 Mikrometer liegt.

13. Uhrenzifferblatt nach einem der Ansprüche 2 bis 12, wobei die Dicke der elektrisch isolierenden Schicht zwischen 500 nm und 1 Mikrometer liegt.

14. Uhrenzifferblatt nach einem der vorhergehenden Ansprüche, wobei eine Verzierung D auf der Oberfläche eines die Anzeige tragenden Substrats angeordnet ist, wobei die Oberfläche auf der für den Benutzer sichtbaren Seite angeordnet ist.

15. Uhr, die ein Uhrenzifferblatt nach einem der Ansprüche 1 bis 14 umfasst.

16. Verfahren zum Herstellen eines Uhrenzifferblatts mit einer organischen leuchtdiodenbasierte Anzeige (10), umfassend:
Aufbringen einer Anode (20);
Aufbringen einer strukturierten Schicht (16) aus farbigem Harz auf der Anode,
wobei die strukturierte Schicht aus farbigem Harz derart strukturiert ist, dass sie Lücken (24) umfasst, in denen ein organischer Schichtstapel (14) in direktem Kontakt mit der Anode steht;
Aufbringen und Strukturieren eines organischen Schichtstapels (14) auf der Anode und der strukturierten Schicht aus farbigem Harz, wobei mindestens eine der organischen Schichten eine lichtemittierende Schicht ist; und Aufbringen einer Kathode (12) auf dem organischen Schichtstapel.

17. Verfahren nach Anspruch 16, wobei das Aufbringen der strukturierten Schicht aus farbigem Harz durch Fotolithografie, Tintenstrahldruck, Siebdruck, Flexographie und/oder Heliographie durchgeführt wird.

18. Verfahren nach einem der Ansprüche 16 bis 17, wobei vor dem Aufbringen des organischen Schichtstapels eine elektrisch isolierende Schicht auf die strukturierte Schicht aus farbigem Harz aufgebracht wird.

## Claims

1. Watch dial having an organic light-emitting diode display (10), the display comprising:
an anode (20);
a structured layer (16) of coloured resin;
an organic layer stack (14) in contact with the anode and with the structured coloured resin layer, said structured layer of coloured resin being structured so as to include gaps (24) in which the stack of organic layers is in direct contact with the anode and at least one of the organic layers being a light-emitting layer; and
a cathode (12) in contact with the organic layer stack.

2. Watch dial according to claim 1, wherein the structured coloured resin layer is coated with an electrically insulating layer.

3. Watch dial according to any of claims 1 to 2, wherein the structured coloured resin layer comprises gaps in which the organic layer stack is in direct contact with the anode.

4. Watch dial according to any of claims 1 to 3, wherein conduction channels are created between the anode and cathode by gaps in the structured coloured resin layer.

5. Watch dial according to any of claims 1 to 4, wherein the cathode is reflective.

6. Watch dial according to any of claims 1 to 5, wherein the cathode is made of aluminium.

7. Watch dial according to any of claims 1 to 6, wherein the thickness of the cathode is comprised in the range from 50 nm to 100 nm.

8. Watch dial according to any of claims 1 to 7, wherein the anode is made of indium-tin oxide.

9. Watch dial according to any of claims 1 to 8, wherein the thickness of the anode is comprised in the range from 100 nm to 200 nm.

10. Watch dial according to any of claims 1 to 9, wherein the thickness of the stack is comprised in the range from 100 nm to 200 nm.

11. Watch dial according to any of claims 1 to 10, wherein the anode and/or the cathode are structured.

12. Watch dial according to any of claims 1 to 11, wherein the thickness of the structured coloured resin layer in contact with the anode is comprised between 500 nm and 1 micron.

13. Watch dial according to any of claims 2 to 12, wherein the thickness of the electrically insulating layer is comprised between 500 nm and 1 micron.

14. Watch dial according to any of the preceding claims, wherein a decoration D is disposed on the surface of a substrate carrying the display, said surface being disposed on the side visible to the user.

15. Watch comprising a watch dial according to any of claims 1 to 14.

16. Method for manufacturing a watch dial having an organic light-emitting diode display (10) comprising:
depositing an anode (20);
depositing a structured coloured (16) resin layer on the anode, said structured layer of coloured resin being structured so as to include gaps (24) in which a stack of organic layers (14) is in direct contact with the anode;
depositing and structuring an organic layer stack (14) on the anode and the structured coloured resin layer, at least one of the organic layers being a light-emitting layer; and
depositing a cathode (12) on the organic layer stack.

17. The method according to claim 16, wherein the structured coloured resin layer is deposited by photolithography, by inkjet printing, by silk screen printing, by flexography and/or by heliography.

18. The method according to any of claims 16 to 17, wherein an electrically insulating layer is deposited on the structured coloured resin layer prior to deposition of the organic layer stack.
